# EUROPÄISCHE PATENTSCHRIFT

(11) **EP 0 465 989 B1**
(45) Veröffentlichungstag und Bekanntmachung des Hinweises auf die Patenterteilung: **07.06.1995**
(21) Anmeldenummer: 91110921.3
(22) Anmeldetag: 02.07.1991
(51) Int. Cl.: H03K 19/091, H01L 27/02

(54) **I2L-Logik-Gatter**
I2L logic gate
Porte logique I2L

(30) Priorität: 11.07.1990 DE 4022139
(43) Veröffentlichungstag der Anmeldung: 15.01.1992
(73) Patentinhaber: TEMIC TELEFUNKEN microelectronic GmbH, 74072 Heilbronn (DE)
(72) Erfinder: Wallner, Claus, W-7101 Ellhofen (DE)
(74) Vertreter: Maute, Hans-Jürgen, Dipl.-Ing.

(56) Entgegenhaltungen:
- GB-A- 2 156 615
- PATENT ABSTRACTS OF JAPAN vol. 5, no. 34 (E-48)(706) 4 March 1981; & JP-A-55 162 261 (NIPPON DENKI K. K.) 17 December 1980.
- PATENT ABSTRACTS OF JAPAN vol. 3, no. 89 (E-126) 28 July 1989;& JP-A-54 066 784 (TOKYO SHIBAURA DENKI K. K.) 29 May 1979.
- IEEE JOURN. OF SOLID-STATE CIRCUITS Bd. SC-14, Nr. 1, Februar 1979,NEW YORK Seiten 59-64; BLAUSCHILD, R.A. ET AL.: 'A Single-Chip I2L PCM Codec.'

## Beschreibung

In der I²L-Technologie - einer Open-Collector-Schaltungstechnik - werden die Logik-Gatter zur Invertierung des Eingangssignals mittels aufwärts betriebener NPN-Schalttransistoren realisiert, wobei jeder vertikale NPN-Schalttransistor mit einem als Stromquelle arbeitenden lateralen PNP-Injektionstransistor verknüpft ist, der die aktive Last am Eingang bzw. Ausgang des Gatters darstellt. Die einzelnen Gatter werden durch Leitbahnen miteinander verbunden und die Ausgangssignale, die an den Kollektoren der Schalttransistoren anliegen, mittels dieser Verdrahtung logisch miteinander verknüpft ("WIRED AND").
Logikanordnungen lassen sich in der I²L-Technologie sehr platzsparend aufbauen; einerseits durch eine funktionelle Integration - der Kollektor des lateralen Injektionstransistors ist gleichzeitig die Basis des vertikalen Schalttransistors - andererseits wegen des Aufwärtsbetriebs - die Emitter der NPN-Schalttransistoren können in einer gemeinsamen P-Wanne zusammengefaßt werden und durch das gemeinsame Emitterpotential sind keine Isolationszonen zwischen den einzelnen Gattern erforderlich. Die Zahl der Ausgänge pro Gatter kann durch den Einsatz von Schalttransistoren mit Mehrfachkollektoren gesteigert werden.

Bei I²L-Logik-Gattern erhält man effektive Aufwärtsstromverstärkungen B_{eff} der Schalttransistoren, die sehr klein sind (typische Werte für B_{eff} liegen im Bereich von 2 bis 5) und zudem stark von den geometrischen Abmessungen (Größe der Basiswanne, Verhältnis der Basisfläche zur Kollektorfläche etc.) abhängen. Bei zunehmender Zahl der Ausgänge pro Gatter, d. h. zunehmender Kollektorzahl des Schalttransistors - der durch den Injektorstrom verursachte Basisstrom pro Kollektor nimmt mit zunehmender Kollektorzahl ab - nimmt die effektive Aufwärtsstromverstärkung B_{eff} stark ab. Ein sicheres Funktionieren der Logik ist aber bei Werten von B_{eff} in der Größenordnung von 1 nicht mehr gewährleistet, so daß die Zahl der Schalttransistoren eines I²L-Gatters - der sog. "FAN-OUT" - auf maximal 3 bis 5 beschränkt ist.

Für viele Logik-Schaltkreise, beispielsweise für Decoder-Schaltungen, werden jedoch mehr als die maximal zulässige Zahl von Ausgängen pro Logik-Gatter benötigt. Man behilft sich in diesen Fällen dadurch, daß man das Gatter in mehrere Teilgatter unterteilt und diese parallelschaltet; die Eingänge der Teilgatter werden über eine gemeinsame Leitbahn miteinander verbunden.
Durch diese Parallelschaltung der untereinander angeordneten Teilgatter ergeben sich jedoch aufgrund des beschränkten zur Verfügung stehenden Platzes Verdrahtungsprobleme zwischen den einzelnen Teilgattern, die bei einer Einebenenverdrahtung ohne zusätzliche Chipfläche nicht gelöst werden können.

Aus der GB 2 156 615 ist eine Halbleiteranordnung gemäß dem Oberbegriff des Patentanspruchs 1 bekannt. Bei dieser Halbleiteranordnung sind die einzelnen Teilgatter - da diese eigentlich eigenständige Logik-Gatter sind - nicht linear hintereinander angeordnet und werden auch nicht auf einfache Weise miteinander verbunden.

Der Erfindung liegt die Aufgabe zugrunde, eine Halbleiteranordnung gemäß dem Oberbegriff des Patentanspruchs 1 mit einer beliebigen Zahl von Ausgängen anzugeben, bei der die einzelnen Teilgatter auf einfache und günstige Weise miteinander verbunden werden können.
Diese Aufgabe wird erfindungsgemäß durch die Merkmale im Kennzeichen des Patentanspruchs 1 gelöst.
Vorteilhafte Weiterbildungen der Halbleiteranordnung ergeben sich aus den Unteransprüchen.

Da die einzelnen Teilgatter und auch alle Anschlußkontakte des Gesamt-Logik-Gatters linear hintereinander angeordnet sind, ist eine einfache Verknüpfung der Teilgatter über die Basisanschlüsse und Emitteranschlüsse der einzelnen Teilgatter und damit auch eine platzsparende Verdrahtung der Ausgänge der Teilgatter bzw. des gesamten I²L-Logik-Gatters möglich.
Die Aufteilung des Gesamt-Logik-Gatters in Teilgatter bzw. die Zahl der kettenförmig verknüpften Teilgatter zum Aufbau eines I²L-Logik-Gatters kann beliebig vorgegeben und gewählt werden.
Wegen der günstigen Platzausnutzung und der einfachen Verdrahtung der I²L-Logik-Gatter kann auch eine Logikanordnung durch Verknüpfung von Logik-Gattern auf einfache Weise und sehr platzsparend realisiert werden; beispielsweise lassen sich matrix-förmige Logik-Arrays, wie beispielsweise ROMs, sehr einfach aufbauen.

Die Erfindung soll nachstehend anhand von Ausführungsbeispielen näher beschrieben werden.

Dabei zeigen:
- Fig. 1: Ersatzschaltbild (Fig. 1a), Schaltungssymbol (Fig. 1b) und Layout (Fig. 1c) eines I²L-Logik-Gatters mit einem FAN-OUT von 3,
- Fig. 2: das Ersatzschaltbild eines I²L-Logik-Gatters mit einem FAN-OUT von 13 und dessen Aufteilung in 4 Teilgatter,
- Fig. 3: die Halbleiteranordnung bzw. das Layout des I²L-Logik-Gatters in Fig. 2 nach dem internen Stand der Technik,
- Fig. 4: die Halbleiteranordnung bzw. das Layout des I²L-Logik-Gatters in Fig. 2 gemäß der Erfindung in Draufsicht,
- Fig. 5: eine perspektivische Darstellung der Halbleiteranordnung bzw. des Layouts eines I²L-Logik-Teilgatters,
- Fig. 6: eine I²L-Logikanordnung aus mehreren I²L-Logik-Gattern.

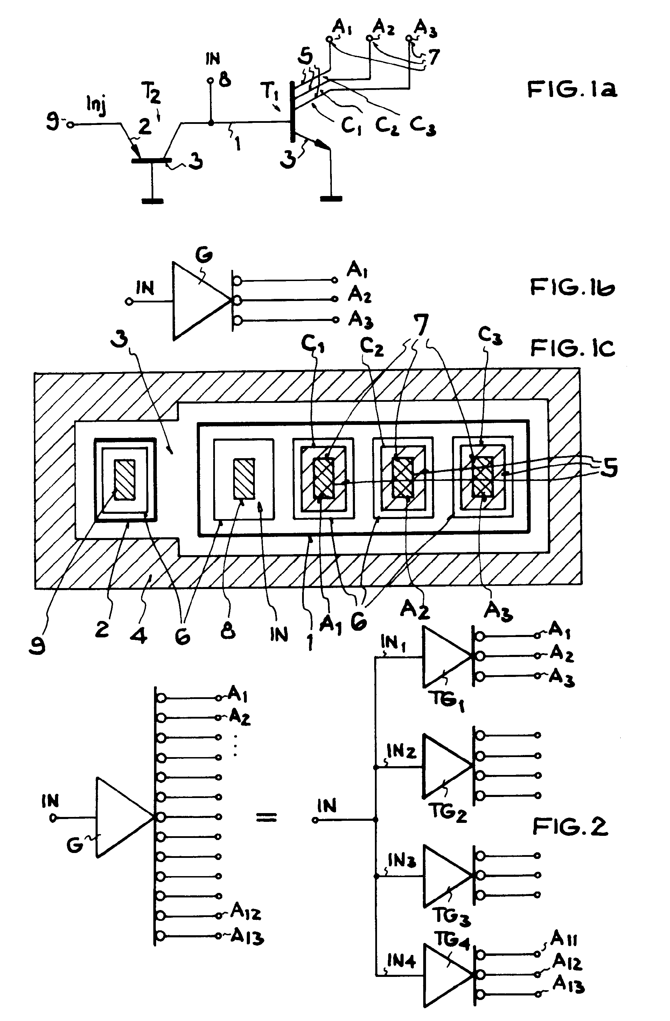

Im Ersatzschaltbild der Figur la ist ein I²L-Logik-Gatter - bestehend aus dem PNP-Injektionstransistor T₂ und dem NPN-Schalttransistor T₁ - dargestellt, das ein FAN-OUT von 3 besitzt; d. h. der NPN-Schalttransistor T₁ weist 3 Kollektoren C₁, C₂, C₃ auf, die die Ausgänge A₁, A₂ und A₃ bilden. Der Eingang IN des Logik-Gatters ist durch den Basis-Anschluß 8 des Transistors T₁ gegeben, der gleichzeitig den Kollektor-Anschluß des Transistors T₂ bildet; der Emitter des Transistors T₂ wird als Injektor bezeichnet. Die Bezugsziffern 1 bis 9 entsprechen denjenigen der Figur 1c und werden nachstehend erläutert.
Die 3 Ausgänge A₁ bis A₃ und der Eingang IN des I²L-Logik-Gatters G sind auch in der symbolischen Darstellung des Logik-Gatters in der Fig. 1b eingezeichnet.
Im Layout der Fig. 1c sind die 3 Kollektoren C₁, C₂, C₃ des Schalttransistors als N⁺-dotierte Gebiete 5 in der gemeinsamen P-Wanne 1 dargestellt. Die P-Wanne 1, die die Basis des NPN-Transistors T₁ und gleichzeitig den Kollektor des PNP-Transistors T₂ bildet, kann durch einen gemeinsamen Diffusionsschritt zusammen mit dem P⁺-Diffusionsgebiet 2 hergestellt werden, das den Emitter des PNP-Transistors T₂ (den Injektor) bildet. Die N⁻-dotierte Epitaxieschicht 3 - gleichzeitig die Basis des PNP-Transistors T₂ und der Emitter des NPN-Transistors T₁ - ist vom N⁺-Diffusionsgebiet 4 umgeben, das als niederohmiger Anschluß für den Emitter des NPN-Transistors T₁ und als Abschirmung zu benachbarten I²L-Logik-Gattern dient. In der Figur 1c ist die Metallisierung mit der Bezugsziffer 6 gekennzeichnet; die Anschlußkontakte bzw. Kontaktfenster zum externen Anschluß der Diffusionsgebiete sind mit der Bezugsziffer 7 für die Kollektoranschlüsse der Kollektoren C₁, C₂, C₃ - d. h. die Ausgänge A₁ bis A₃ - mit der Bezugsziffer 8 für den Basisanschluß des NPN-Transistors T₁, der den Eingang IN des Logik-Gatters bildet, und mit der Bezugsziffer 9 für den Emitteranschluß des PNP-Transistors T₂, der den Injektor bildet, gekennzeichnet.

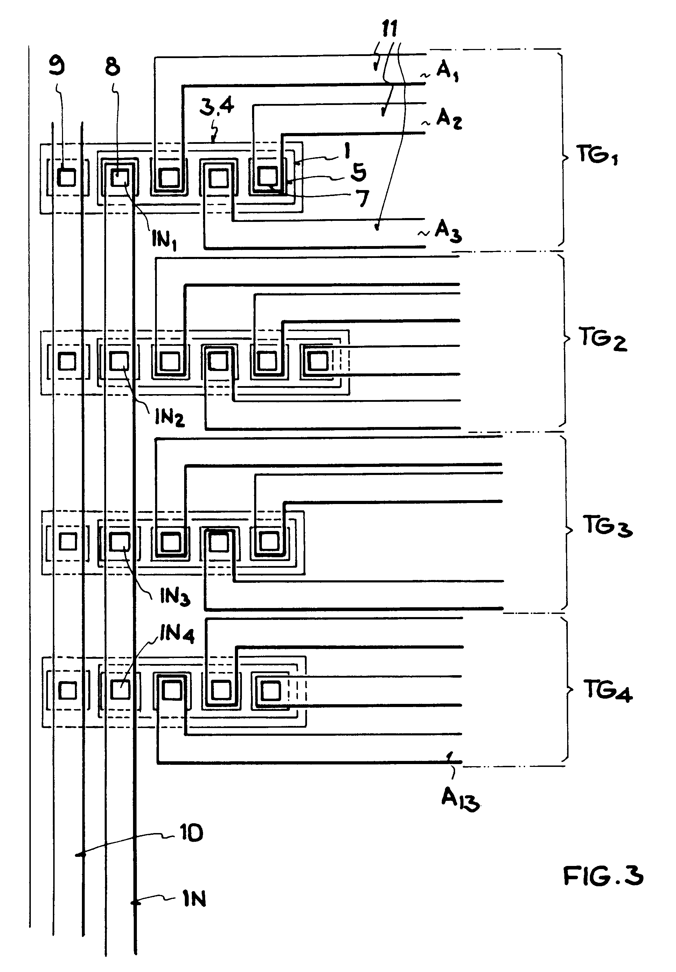

Das I²L-Logik-Gatter G der Figur 2 mit einem FAN-OUT von 13 wird durch eine Parallelschaltung von 4 Teilgattern TG₁ bis TG₄ realisiert. Die Teilgatter TG₁ bis TG₄ - die jeweils einen PNP-Injektionstransistor T₂ und einen Mehrfachkollektor-NPN-Schalttransistor T₁ aufweisen - besitzen jeweils 3 oder 4 Kollektoren, d. h. 3 oder 4 Ausgänge, so daß die Bedingung der maximal zulässigen Anzahl von 5 Ausgängen pro I²L-Gatter gewährleistet ist.
Wie die der Schaltungsanordnung der Figur 2 entsprechende Halbleiteranordnung (Layout) der Figur 3 zeigt, sind die verschiedenen Teilgatter TG₁ bis TG₄ vertikal untereinander angeordnet. Die Bezugsziffern der Figur 3 entsprechen denjenigen der Figur 1, die Abschirmdiffusion ist in der Figur 3 nicht dargestellt.
Die Parallelschaltung der Teilgatter wird dadurch erreicht, daß die 4 Basisanschlüsse bzw. Basisanschlußkontakte 8 der 4 NPN-Schalttransistoren bzw. die Eingänge IN₁ bis IN₄ vertikal miteinander verbunden werden und die Emitter 2 bzw. die Emitteranschlußkontakte 9 der 4 Injektionstransistoren über eine vertikal verlaufende gemeinsame Injektorschiene 10 miteinander verknüpft sind.
Wie aus der Figur 3 ersichtlich wird, ergeben sich Platzprobleme bei der Verdrahtung der Ausgänge A₁ bis A₁₃ der einzelnen Teilgatter; wenn Leiterbahnkreuzungen vermieden werden sollen, ist die Führung der verschiedenen Leiterbahnen 11 problematisch.

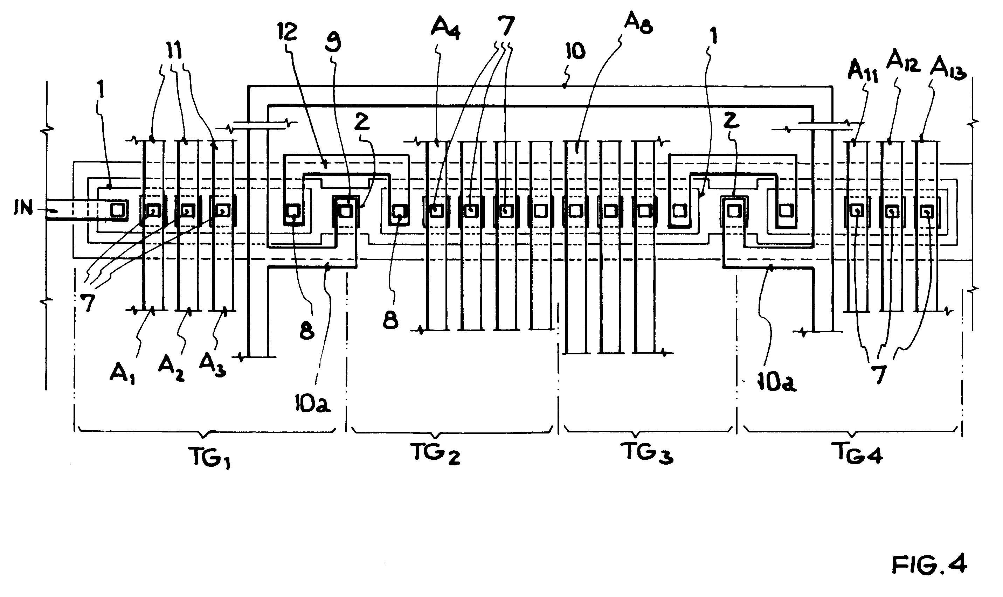

In der Figur 4 ist die erfindungsgemäße Halbleiteranordnung dargestellt. Die vier Teilgatter TG₁ bis TG₄ sind nicht mehr vertikal untereinander sondern linear hintereinander kettenförmig angeordnet; die P-Wannen 1 der beiden mittleren Teilgatter TG₂ und TG₃ wurden zusammengefaßt. Anstatt der normalerweise vier erforderlichen Injektionstransistoren sind nur zwei Injektionstransistoren vorhanden, deren Emitter 2 jeweils zwei Teilgatter TG₁ und TG₂ bzw. TG₃ und TG₄ versorgen.
Das Eingangssignal wird am Eingangsanschluß IN an der P-Wanne 1 des äußersten Teilgatters TG₁ eingespeist, an der gegenüberliegenden Seite dieser gleichen P-Wanne wieder entnommen (Basisanschluß 8 des Teilgatters TG₁), an der P-Wanne des nächsten Teilgatters TG₂ (Basisanschluß 8) wieder eingespeist und so weiter. Die P-Wanne 1 stellt hier nicht nur - über die Basisanschlüsse - den jeweiligen Eingangsanschluß der Teilgatter dar, sondern bildet auch einen Teil der Verdrahtung. Da die Verbindung 12 von einer P-Wanne zur anderen über die Verdrahtung, beispielsweise die Metallisierung, realisiert ist, können die Injektionstransistoren zweier benachbarter Teilgatter nicht direkt miteinander verbunden werden; deshalb wird in jedem Teilgatter auf einen Kollektoranschluß verzichtet, über dessen Stelle die Anschlußleitung 10a zur gemeinsamen Injektorleitung 10 geführt wird. Die Anschlußleitung 10a zu den Emittern 2 der Injektionstransistoren bzw. zu den Emitterkontakten 9 wird dabei an der Verbindungsleitung 12 der P-Wannen 1 vorbeigeführt.

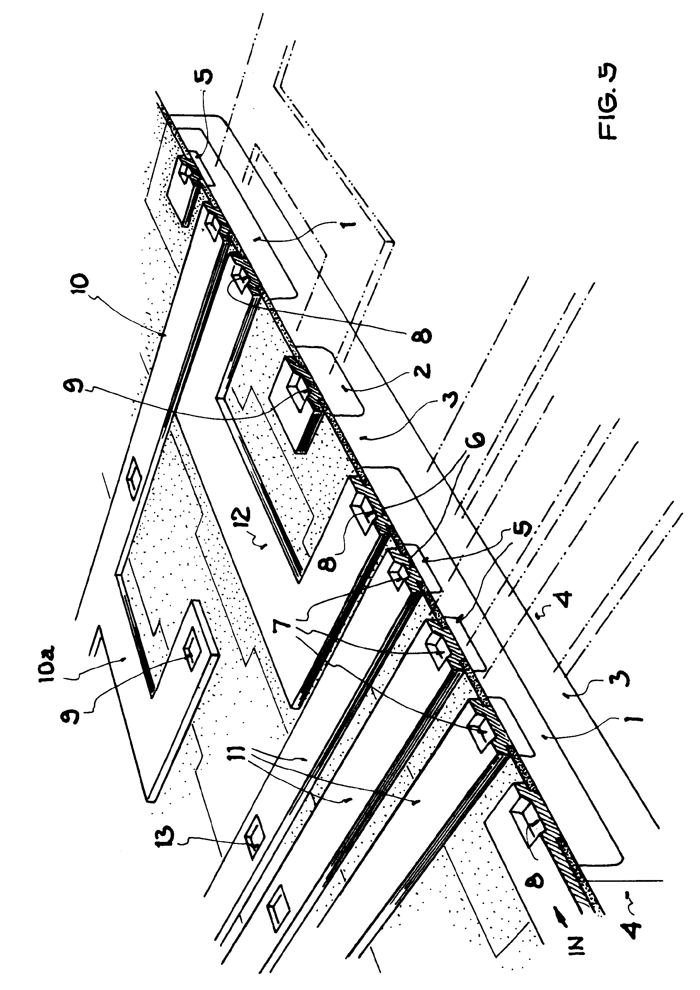

In der Figur 5 ist zur Verdeutlichung des Aufbaus der erfindungsgemäßen Struktur des I²L-Logik-Gatters ein Teilgatter und dessen Verbindung zum nächsten Teilgatter in einer perspektivischen Ansicht dargestellt.
Die in der Figur 5 aufgeführten Bezugsziffern entsprechen wiederum denjenigen der Figur 1; die Bezugsziffer 12 bezeichnet die Verbindungsleitung zwischen den Basisanschlüssen 8, die Bezugsziffer 13 die Verknüpfungsstelle mit einem benachbarten Logik-Gatter, an der die logische Signalverknüpfung der Ausgangssignale vorgenommen wird.

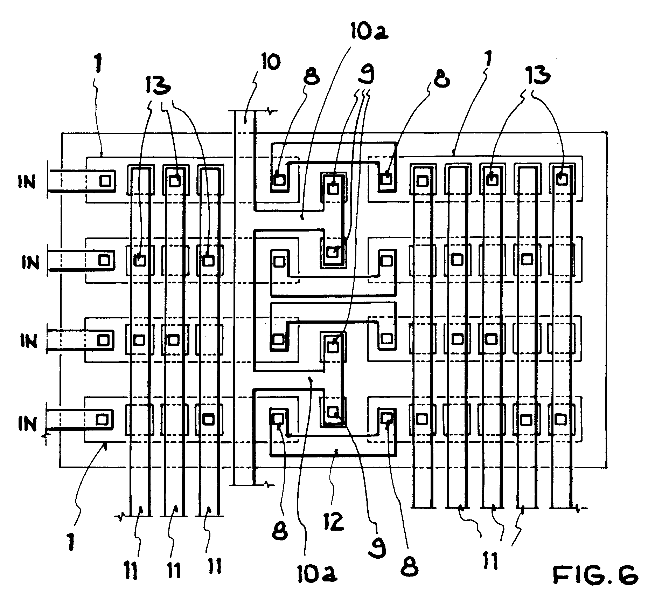

In der Figur 6 ist ein Ausführungsbeispiel für eine aus I²L-Logik-Gattern aufgebaute I²L-Logik-Anordnung - eine Decodierschaltung für 8 Ausgangssignale - dargestellt. Bei dieser Logikanordnung werden vier I²L-Logik-Gatter mit jeweils einem Eingangsanschluß für das Eingangssignal IN und 8 Ausgängen parallelgeschaltet, wobei die vier I²L-Logik-Gatter jeweils in zwei hintereinander angeordnete Teilgatter mit 3 bzw. 5 Ausgängen unterteilt wurden. Der Platzaufwand für eine derartige Logikanordnung kann dadurch weiter verringert werden, daß jeweils zwei I²L-Logik-Gatter spiegelbildlich untereinander angeordnet werden, so daß die Injektor-Verbindungsleitungen dieser beiden Logik-Gatter zu einer gemeinsamen Verbindungsleitung 10a zusammengefaßt werden können. Die allen Logik-Gattern gemeinsame Injektorleitung 10 wird nach außen geführt.
Für die Decodierschaltung der Figur 6 werden nicht alle zur Verfügung stehenden Ausgänge der Logikanordnung benötigt; die angeschlossenen Ausgänge bzw. die NPN-Schalttransistoren, die in Verbindung mit der darüberführenden Leitbahn 11 stehen, sind in der Figur 6 durch die Kontaktfenster 13 gekennzeichnet.

## Patentansprüche

1. Halbleiteranordnung eines durch Unterteilung in Teilgatter (TG) eine Vielzahl von Ausgängen (A) aufweisenden I²L-Logik-Gatters (G), bei der jedes Teilgatter (TG) aus einem PNP-Injektionstransistor (T₂) und einem NPN-Mehrfachkollektor-Schalttransistor (T₁) gebildet wird und mehrere linear hintereinander angeordnete Anschlußkontakte (7, 8, 9) aufweist, dadurch gekennzeichnet, daß die einzelnen Teilgatter (TG) linear hintereinander angeordnet sind, daß die einzelnen Teilgatter (TG) über Verbindungen der linear hintereinander angeordneten Basisanschlüsse (8) der Schalttransistoren (T₁) und der Emitteranschlüsse (9) der Injektionstransistoren (T₂) miteinander verknüpft sind, daß der Basisanschluß eines Teilgatters mit dem Basisanschluß des jeweils nächsten Teilgatters verbunden ist, und daß die Emitteranschlüsse der Injektionstransistoren über Anschlußleitungen (10a) mit einer allen Teilgattern (TG) des Gesamt-Logik-Gatters (G) gemeinsamen Injektorleitung (10) verbunden sind.

2. Halbleiteranordnung nach Anspruch 1, dadurch gekennzeichnet, daß die Verbindung der Basisanschlüsse (8) der Schalttransistoren (T₁) innerhalb der Teilgatter (TG) über P-Diffusions-Zonen (1) und zwischen den Teilgattern (TG) über leitende Verbindungen (12) hergestellt wird.

3. Halbleiteranordnung nach Anspruch 1 oder 2, dadurch gekennzeichnet, daß die Anschlußleitung (10a) zwischen den Emitteranschlüssen (9) der Injektionstransistoren (T₂) und der gemeinsamen Injektorleitung (10) in jedem Teilgatter (TG) über die Oberfläche eines nicht kontaktierten Kollektorgebiets des Schalttransistors (T₁) geführt ist.

4. Halbleiteranordnung nach einem der Ansprüche 1 bis 3, dadurch gekennzeichnet, daß für jeweils zwei hintereinander angeordnete Teilgatter ein gemeinsamer Emitteranschluß (9) des Injektionstransistors (T₂) vorgesehen ist, der zwischen den beiden Basisanschlüssen (8) der hintereinanderliegenden Teilgatter angeordnet ist.

5. Halbleiteranordnung nach einem der Ansprüche 1 bis 4, dadurch gekennzeichnet, daß das äußerste Teilgatter (TG₁) des Gesamt-Logik-Gatters (G) einen Eingangsanschluß (IN) aufweist, und daß die Ausgangsanschlüsse (A) des Logik-Gatters durch die Kollektoranschlüsse (7) der Schalttransistoren (T₁) gebildet werden.

6. Verwendung mehrerer Halbleiteranordnungen eines I²L-Logik-Gatters nach einem der Ansprüche 1 bis 5 zum Aufbau einer Halbleiteranordnung eines I²L-Logik-Arrays.

7. Verwendung nach Anspruch 6, dadurch gekennzeichnet, daß mehrere Halbleiteranordnungen durch parallelgeführte Leiterbahnen (11) miteinander verbunden werden.

8. Verwendung nach Anspruch 6 oder 7, dadurch gekennzeichnet, daß zwei untereinanderliegende Halbleiteranordnungen derart spiegelbildlich angeordnet werden, daß sie eine gemeinsame Anschlußleitung (10a) zur allen Logik-Gattern gemeinsamen Injektorleitung (10) aufweisen.

9. Verwendung nach einem der Ansprüche 6 bis 8 zum Aufbau einer ROM-Struktur mit einer beliebigen Anzahl von Zeilen und Spalten.

10. Verwendung nach einem der Ansprüche 6 bis 9 zum Aufbau einer Decodier-Einrichtung mit einer beliebigen Anzahl von Zeilen und Spalten.

## Claims

1. A semiconductor arrangement of an I²L-logic gate (G) comprising a plurality of outputs (A) by virtue of its subdivision into subsidiary gates (TG), wherein each subsidiary gate (TG) is formed by a PNP injection transistor (T₂) and a NPN multiple collector switching transistor (T₁) and comprises a plurality of terminal contacts (7, 8, 9) arranged linearly in series, characterised in that the individual subsidiary gates (TG) are linked to one another via connections between the linearly series-arranged base terminals (8) of the switching transistors (T₁) and the emitter terminals (9) of the injection transistors (T₂), that the base terminal of one subsidiary gate is connected to the base terminal of the respective next subsidiary gate, and that the emitter terminals of the injection transistors are connected via connection lines (10a) to an injector line (10) common to all the subsidiary gates (TG) of the overall logic gate (G).

2. A semiconductor arrangement as claimed in Claim 1, characterised in that the connection of the base terminals (8) of the switching transistors (T₁) is established via P-diffusion zones (1) within the subsidiary gates (TG) and via conductive connections (12) between the subsidiary gates (TG).

3. A semiconductor arrangement as claimed in Claim 1 or 2, characterised in that the connection line (10a) between the emitter terminals (9) of the injection transistors (T₂) and the common injector line (10) in each subsidiary gate (TG) leads across the surface of a non-contacted collector zone of the switching transistor (T₁).

4. A semiconductor arrangement as claimed in one of Claims 1 to 3, characterised in that in each case for two series-arranged subsidiary gates a common emitter terminal (9) of the injection transistor (T₂) is provided, which emitter terminal (9) is arranged between the two base terminals (8) of the series-arranged subsidiary gates.

5. A semiconductor arrangement as claimed in one of Claims 1 to 4, characterised in that the outermost subsidiary gate (TG₁) of the overall logic gate (G) comprises an input terminal (IN), and that the output terminals (A) of the logic gate are formed by the collector terminals (7) of the switching transistors (T₁).

6. Use of a plurality of semiconductor arrangements of an I²L-logic gate in accordance with one of Claims 1 to 5 for the construction of a semiconductor arrangement of an I²L-logic array.

7. Use as claimed in Claim 6, characterised in that a plurality of semiconductor arrangements are connected to one another by conductor paths (11) extending in parallel.

8. Use as claimed in Claim 6 or 7, characterised in that two semiconductor arrangements arranged one below another are arranged in mirror-inverted manner such that they possess a common connection line (10a) to the injector line (10) common to all the logic gates.

9. Use as claimed in one of Claims 6 to 8 for the construction of a ROM structure with an arbitrary number of rows and columns.

10. Use as claimed in one of Claims 6 to 9 for the construction of a decoder device with an arbitrary number of rows and columns.

## Revendications

1. Dispositif semi-conducteur d'une porte logique I²L (G) présentant un grand nombre de sorties (A) par division en sous-portes (TG), dont chaque sous-porte (TG) est formée d'un transistor d'injection PNP (T₂) et d'un transistor de commutation NPN multicollecteur (T₁) et présente plusieurs contacts de connexion (7, 8, 9) placés linéairement l'un derrière l'autre, caractérisé en ce que les différentes sous-portes (TG) sont placées linéairement l'une derrière l'autre, que les différentes sous-portes (TG) sont rattachées (combinées) entre elles par des liaisons des connexions de base (8) des transistors de commutation (T₁) et des connexions d'émetteur (9) des transistors d'injection (T₂), connexions qui sont placées linéairement l'une derrière l'autre, que la connexion de base d'une sous-porte est reliée chaque fois à la connexion de base de la sous-porte suivante, et que les connexions d'émetteur des transistors d'injection sont reliées par des lignes de connexion (10a) à une ligne d'injecteur (10) commune à toutes les sous-portes (TG) de l'ensemble de la porte logique (G).

2. Dispositif semi-conducteur selon la revendication 1, caractérisé en ce que la liaison des connexions de base (8) des transistors de commutation (T₁) est réalisée par des zones diffusées P (1) à l'intérieur des sous-portes (TG) et par des liaisons conductrices (12) entre les sous-portes (TG).

3. Dispositif semi-conducteur selon la revendication 1 ou 2, caractérisé en ce que la ligne de connexion (10a) entre les connexions d'émetteur (9) des transistors d'injection (T₂) et la ligne d'injecteur (10) commune passe, dans chaque sous-porte (TG), sur la surface d'une région de collecteur sans contact du transistor de commutation (T₁).

4. Dispositif semi-conducteur selon une des revendications 1 à 3, caractérisé en ce que, pour chaque fois deux sous-portes placées l'une derrière l'autre, on a prévu une connexion d'émetteur (9) commune du transistor d'injection (T₂), connexion qui est placée entre les deux connexions de base (8) des sous-portes disposées l'une derrière l'autre.

5. Dispositif semi-conducteur selon une des revendications 1 à 4, caractérisé en ce que la sous-porte extérieure (TG₁) de l'ensemble de la porte logique (G) présente une connexion d'entrée (EN) et que les connexions de sortie (A) de la porte logique sont formées par les connexions de collecteur (7) des transistors de commutation (T₁).

6. Utilisation de plusieurs dispositifs semiconducteurs d'une porte logique I²L selon une des revendications 1 à 5 pour réaliser un dispositif semi-conducteur d'un réseau logique I²L.

7. Utilisation selon la revendication 6, caractérisée en ce que plusieurs dispositifs semi-conducteurs sont reliés entre eux par des pistes conductives (11) disposées en parallèle.

8. Utilisation selon la revendication 6 ou 7, caractérisée en ce que deux dispositifs semi-conducteurs, placés l'un sous l'autre, sont agencés symétriquement de manière qu'ils présentent une ligne de connexion (10a) commune menant à une ligne d'injecteur (10) commune à toutes les portes logiques.

9. Utilisation selon une des revendications 6 à 8 pour réaliser une structure de mémoire permanente (ROM) comportant un nombre de lignes et de colonnes choisissable à volonté.

10. Utilisation selon une des revendications 6 à 9 pour réaliser un dispositif de décodage comportant un nombre de lignes et de colonnes choisissable à volonté.
